# EUROPEAN PATENT APPLICATION

(11) **EP 2 658 281 A1**
(43) Date of publication of application: **30.10.2013**
(21) Application number: 11851995.8
(22) Date of filing: 14.12.2011
(51) Int. Cl.: H04R 3/00, H03G 3/32, H04N 5/225, H04S 7/00

(54) **AUDIO CONTROL DEVICE AND IMAGE CAPTURE DEVICE**

(30) Priority: 20.12.2010 JP 2010282914; 20.12.2010 JP 2010282915
(71) Applicant: Nikon Corporation, Tokyo 100-8331 (JP)
(72) Inventor: YOSHIMATSU, Eiji, Tokyo 100-8331 (JP)
(74) Representative: Hewett, Jonathan Michael Richard
(86) International application number: PCT/JP2011/078878
(87) International publication number: WO 2012/086485

(57) **Abstract**

An audio control device includes: a situation determination unit that determines a situation of environment when a sound is obtained; and a control unit that applies any one of automatic level control and a gain fixation control to a sound obtained by a sound obtaining unit, the control unit controlling gain automatically based on a result of determination by the situation determination unit such that a sound level is at a constant level in the automatic level control and fixing gain to a predetermined valuo in the gain fixation control.

## Description

### TECHNICAL FIELD

The present invention relates to an audio control device and an imaging device.

### BACKGROUND ART

An audio signal processing device is known which performs, to control recording levels upon audio recording, automatic level control (ALC) in which recording gain is automatically controlled depending on a level of input voice. The ALC is effective when importance is attached to the content of a speech of a person (for example, when in audio recording of a conference). On the other hand, in audio recording in an occasion where importance is attached to ambience and continuation of sounds as in, for example, concerts, gain fixation in which recording gain is fixed to a constant value without using the ALC is effective.

### CITATION LIST

### PATENT LITERATURE

Patent Literature 1 JP 2005-167380 A

### SUMMARY OF INVENTION

### TECHNICAL PROBLEM

Heretofore, there has been no recording device which can automatically switch between ALC and gain fixation depending on a situation.

### SOLUTION TO PROBLEM

according to the 1st aspect of the present invention, an audio control device comprises: a situation determination unit that determines a situation of environment when a sound is obtained; and a control unit that applies any one of automatic level control and a gain fixation control to a sound obtained by a sound obtaining unit, the control unit controlling gain automatically based on a result of determination by the situation determination unit such that a sound level is at a constant level in the automatic level control and fixing gain to a predetermined value in the gain fixation control.
According to the 2nd aspect of the present invention, in the audio control apparatus according to the 1 st aspect, it is preferred that the sound obtaining unit includes a first obtaining unit that has a directivity in a direction toward a user and a second obtaining unit that has a directivity in a direction other than the direction toward the user, and the control unit applies the automatic level control to a sound obtained by the first obtaining unit regardless of the result of determination by the situation determination unit and applies to a sound obtained by the second obtaining unit any one of the automatic level control in which gain is automatically controlled such that the sound level is at the constant level and the gain fixation control in which gain is fixed to the predetermined value based on the result of determination by the situation determination unit.
According to the 3rd aspect of the present invention, the audio control device according to the 1st aspect may further comprise: a voice determination unit that determines whether or not the sound obtained by the sound obtaining unit is a voice of a proscribed person, and it is preferred that when the voice determination unit determines that the sound obtained by the sound obtaining unit is not a voice of the prescribed person, the control unit applies to the sound obtained by the obtaining unit any one of the automatic level control in which gain is automatically controlled such that the sound level is at a constant level and the gain fixation control in which gain is fixed to the predetermined value based on the result of determination by the situation determination unit, or when the voice determination unit determines that the sound obtained by the sound obtaining unit is the voice of the prescribed person, the control unit applies the automatic level control to the sound obtained by the obtaining unit regardless of the result of determination by the situation determination unit.
According to the 4th aspect of the present invention, in the audio control device according to any one of the 1st to 3rd aspects, it is preferred that the situation determination unit detects a difference in situation between a situation at previous audio recording and a situation at present audio recording, and when the situation determination unit determines that there is no change in situation between the situation at the previous audio recording and the situation at the present audio recording, the control unit applies the control at the previous audio recording as a control for the present audio recording.
According to the 5th aspect of the present invention, in the audio control device according to any one of the 1st to 4th aspects, it is preferred that when the situation determination unit determines that the situation is a situation in which the content of speech is important, the control unit applies the automatic level control.
According to the 6th aspect of the present invention, in the audio control device according to any one of the 1st to 5th aspects, it is preferred that when the situation determination unit determines that the situation is a situation in which importance is to be attached to ambience, the control unit applies the gain fixation control.
According to the 7th aspect of the present invention, the audio control device according to any one of the 1st to 5th aspect may further comprise: an indication unit that indicates any one the automatic level control and the gain fixation control depending on an operation by a user, and it is preferred that when any one of the automatic level control and the gain fixation control is indicated by the indication unit, the control unit applies any one of the automatic level control and the gain fixation control, putting priority to the indication by the indication unit.
According to the 8th aspect of the present invention, in the audio control device according to any one of the 1st to 7th aspects, it is preferred that when the control unit applies the gain fixation control, the control unit uses a gain corresponding to the sound level.
According to the 9th aspect of the present invention, the audio control device according to any one of the 1st to 8th aspects may further comprise: a recording control unit that records the sound obtained by the sound obtaining unit in a recording medium.
According to the 10th aspect of the present invention, an imaging device comprises: the audio control device according to any one of the 1st to 9th aspects; and an image capturing unit that performs image capturing of a photographic subject, wherein the situation determination unit determines a situation based on a result of the image capturing by the image capturing unit.
According to the 11th aspect of the present invention, in the imaging device according to the 10th aspect, it is preferred that the situation determination unit detects a face of a person on an image captured by the image capturing unit, and when the situation determination unit has detected the face of the person, the control unit applies the automatic level control or when the situation determination unit has not detected the face of the person, the control unit applies the gain fixation control.
According to the 12th aspect of the present invention, in the imaging device according to the 11th aspect, it is preferred that when the situation determination unit detects a plurality of faces of the persons, the situation determination unit determines whether or not the persons are moving objects, and when the situation determination unit has determined that the persons are moving objects, the control unit applies the automatic level control or when the situation determination unit has determined that the persons are not moving objects, the control unit applies the gain fixation control.

### ADVANTAGEOUS EFFECT OF THE INVENTION

According to the present invention, appropriate control of recording can be performed even if the user has no awareness of sounds that are to be obtained.

### BRIEF DESCRIPTION OF THE DRAWINGS

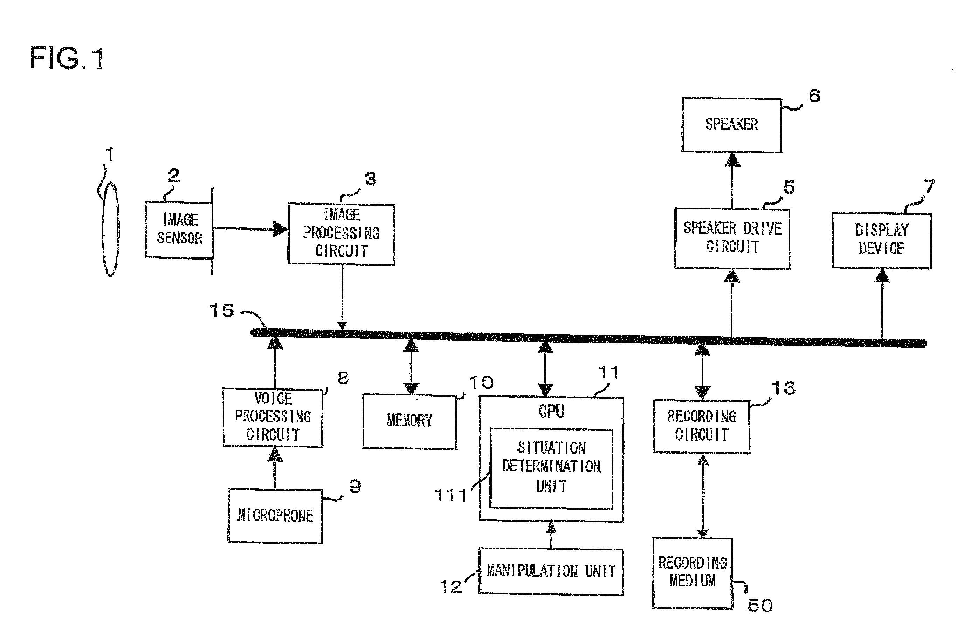

FIG. 1 presents a control block diagram showing an imaging device according to a first embodiment of the present invention;
FIG. 2 presents a main flowchart illustrating processing procedures at the time of movie shooting;
FIG 3 presents a flowchart illustrating details of a recording method selection processing;
FIG. 4 presents a flowchart illustrating details of gain fixation processing;
FIG. 5 presents a main flowchart illustrating processing procedures at the time of movie shooting according to a second embodiment;
FIG. 6 presents external views showing an imaging device according to a third embodiment, with (a) being a front elevation and (b) being a rear elevation;
FIG. 7 presents a control block diagram showing an imaging device according to a third embodiment;
FIG. 8 presents a flowchart illustrating details of audio recording selection processing according to a third embodiment;
FIG. 9 presents a top external view of an imaging device according to a fourth embodiment;
FIG. 10 presents a control block diagram showing an imaging device according to a fourth embodiment; and
FIG. 11 presents a flowchart illustrating details of audio recording selection processing according to a fourth embodiment.

### DESCRIPTION OF EMBODIMENTS

Referring to the drawings, an imaging device according to an embodiment of the present invention is explained taking a digital camera 100 as an example. Note that an imaging device may include any apparatus that is capable of performing movie shooting with audio recording, examples of which include a camcorder, a digital camera and a cellular phone and so on.

### -First Embodiment-

An image of a light flux of a photographic subject that passed through a photographic lens 1 is captured by an image sensor 2. The image sensor 2 that has captured the image of the light flux of the photographic subject outputs an image pickup signal. The image pickup signal is subjected to various processing by an image processing circuit 3 and converted into image data. When a photographing mode is set, the image capturing is repeated by the image sensor 2 and each time the image data obtained in the image processing circuit 3 is successively renewed and displayed on a display device 7 such as a liquid crystal monitor.

In the above situation, when a movie recording start operation (for example, pressing operation of a movie recording button) is performed, the image sensor 2 starts movie shooting while when a movie recording stop operation (for example, release of pressing a movie recording button) is performed, the image sensor 2 stops the movie shooting. In the meantime, the image pickup signal that is output from the image sensor 2 is converted into movie data in the image processing circuit 3. Further, at the time of movie shooting, a sound is input into the image processing circuit 3 through a microphone 9 and is output therefrom as an audio signal. The audio signal is subjected to processing such as amplification in an audio processing circuit 8 and converted into predetermined audio data. The generated movie data and audio data are combined with each other to form a movie file. The movie file is recorded in a recording medium 50 such as a memory card through a recording circuit 13.

In a reproduction mode, movie file recorded in the recording medium 50 is read out The read out movie file is output to the display device 7 through the image processing circuit 3. As a result, a movie corresponding to the movie file is reproduced in the display device 7. On this occasion, the audio data that constitutes the movie file is output to a speaker 6 through a speaker drive circuit 5. As a result, a sound that corresponds to the audio data is output from the speaker 6.

CPU 11 controls the respective circuits described above and circuits that are not shown in response to inputs from a manipulation unit 12 so as to perform various processing including movie shooting and reproduction. Note that the CPU 11 functionally includes a situation determination unit 111 that determines a situation around the digital camera 100 when the sound is input by a microphone 9. Examples of the manipulation unit 12 include the above movie recording button, a power button, a recording level setup key, a recording method setup key that performs a setting operation to set a recording method manually as exampled later, and various manipulation members for use in a reproduction operation and for inputting information and so on.

Then, recording control in the digital camera 100 is explained.
The audio processing circuit 8 is provided with a function of known automatic level control (hereafter, referred to as ALC). The ALC function is a function with which a recording gain is automatically adjusted depending on a sound input level of the audio signal that is output from the microphone 9 such that the recording level at the time of movie shooting may become substantially constant. The audio processing circuit 8 decreases recording gain when the sound input level is high and increases recording gain when the sound input level is low by the ALC function. For example, on an occasion of a conference, the distance from the microphone 9 may differ from person to person and loudness of voice may differ from person to person. In such a case, the audio processing circuit 8 can control voices of all the members to substantially the same recording level by using the above ALC function. As a result, in the reproduction mode, voices of all the members can be reproduced at substantially the same level.

On the other hand, the audio processing circuit 8 can cancel the ALC function to fix the recording gain at a constant value (fixed value) (hereafter, referred to as gain fixation). Examples of the case in which ALC function is cancelled may include a case where importance is attached to ambience or continuation of sounds such as in movie shooting of, for example, landscape, concerts, and sports and so on. A big feature of the digital camera 100 is in that the CPU 11 automatically selects the ALC function or gain fixation depending on a situation. In addition, when gain fixation is selected, the CPU 11 automatically decides the fixed value of gain.

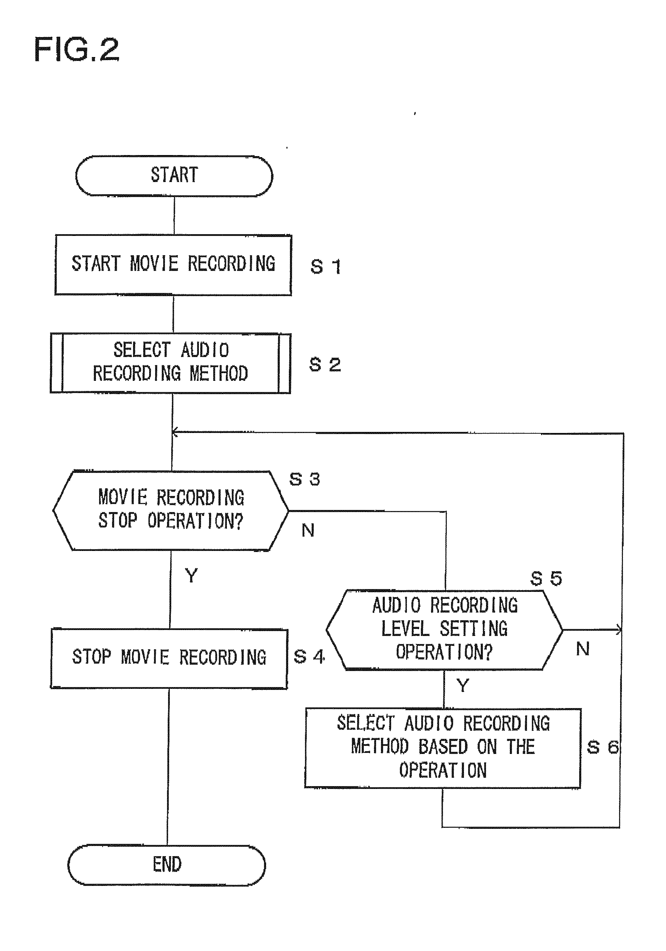

FIG. 2 to FIG. 4 present flowchart each illustrating a procedure at the time of movie shooting. The processing in FIG. 2 to FIG. 4 is performed by running the program in the CPU 11. This program is stored in a memory (not shown) and when a movie recording start operation is performed, the program is started up and executed by the CPU 11.
In step S1, the CPU 11 causes the image sensor 2 to start movie shooting. In step S2, the CPU 11 selects a recording method in movie shooting. Details of the above will be described later. Here, any one of the "ALC", "gain fixation (gain being high)" and "gain fixation (gain being low)" is selected and subsequently, audio data is obtained by using the selected recording method in synchronization with the movie shooting. The selection of the recording method may be performed before the movie shooting is started.

In step S3, the CPU 11 decides whether or not a movie recording stop operation has been performed. When no movie recording stop operation has been performed, the CPU 11 denies step S3 while in step S5, the CPU 11 decides whether or not a manual setting operation for the recording method has been performed by a photographer by using the manipulation unit 12. When no manual setting operation for the recording method has been performed, the CPU 11 denies step S5 and the control returns to step S3. When a manual setting operation for the recording method has been performed and a command signal is input from the manipulation unit 12, the CPU 11 affirms step S5 and in step S6, the CPU 11 sets the recording method based on the setting operation of the recording method. That is, the setting of recording method by manual operation by the photographer is given priority to the automatic selection in step S2. Here, the manual setting of the recording method may be performed, for example, by selecting any one of "ALC", "gain fixation (gain being high)", "gain fixation (medium gain)", "gain fixation (gain being low)", and "no audio recording".

Note that regardless of whether automatic setting or manual setting is used, it is preferred to display the content of the setting on a screen of the display device 7 by using icons or the like.

When a movie recording stop operation is performed, the CPU 11 affirms step S3 and in step S4, the CPU 11 causes the image sensor 2 to stop the movie shooting to terminate the processing. The movie file (including audio data) obtained by the movie shooting is recorded in the recording medium 50.

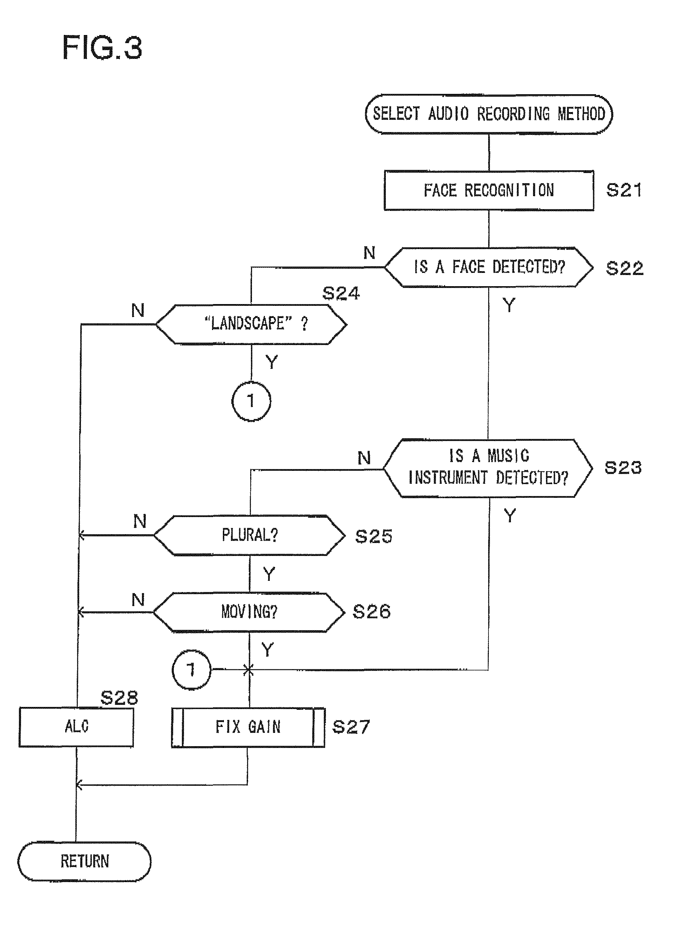

FIG. 3 presents a flowchart illustrating the details of the recording method selection processing (step S2).
In step S21, the CPU 11 commands the image processing circuit 3 to start face recognition processing on movie data after the movie shooting is started. This is a function to recognize a face of a person in the image by a known algorithm, which is originally used in automatic control of focusing and exposure. Here, the results of face recognition are used also in the selection of the recording method.

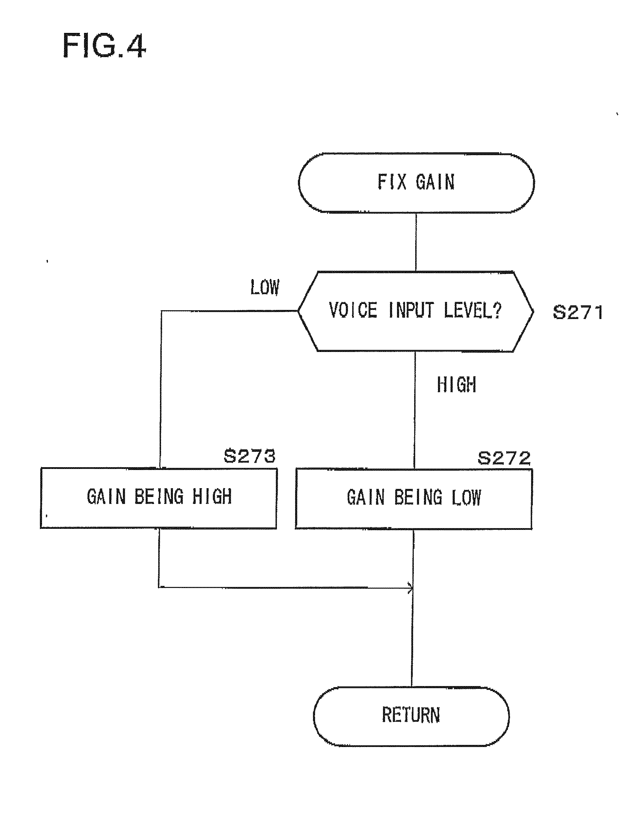

In step S22, the CPU 11 decides wether or not a face is detected by face recognition processing. When a face is detected, the CPU 11 affirms step S22 and the control proceeds to step S23. In step S23, CPU 11 commands the image processing circuit 3 to perform musical instrument detection by using a face recognition technology in order to determine whether or not the shooting relates to shooting of a concert. This is to determine whether or not a musical instrument is present in the image by a technique of, for example, template matching or the like. For example, when an object having a guitar-like shape is recognized around a waist of a person by the image processing circuit 3, the situation determination unit 111 of the CPU 11 judges that the shooting is shooting of a concert. On this occasion, it is a situation where importance is to be attached to ambience, and the CPU 11 performs gain fixation processing in step S27. Note that the details of gain fixation processing will be described later referring to FIG. 4.

When no musical instrument has been detected in step S23 by the image recognition technology, the CPU 11 denies step S23 and the control proceeds to step S25. In step S25, the CPU 11 decides whether or not a plurality of faces is detected by the face recognition processing in step S22. When the plurality of faces is detected, the CPU 11 affirms step S25 and the control proceeds to step S26. In step S26, the CPU 11 commands the image processing circuit 3 to perform known moving object detection and decides whether or not photographic subjects (i.e., persons corresponding to the detected faces) are moving to an extent equal to or more than a predetermined value. When step S26 is affirmed, that is, the persons are moving to the extent equal to or more than the predetermined value, the situation determination unit 111 judges that the shooting relates to shooting of some sport. In this case, it is a situation where importance is to be attached to ambience, and the CPU 11 performs the gain fixation processing as explained later in step S27.

On the other hand, when step S26 is denied, that is, when a plurality of persons are present but substantially no movement is noticed in them, the situation determination unit 111 judges that the shooting relates to shooting of a conference. In this case, it is a situation where importance is to be attached to the content of speech rather than ambience, and the CPU 11 selects the ALC function in step S28. When the ALC function is selected, the CPU 11 periodically checks audio input levels until the movie recording is completed and the audio processing circuit 8 automatically controls the recording gain so that the recording level becomes substantially constant.

When step S25 is denied (when there is a single person), there is a high possibility that conversation is made between the photographer and the photographic subject. In this case too, it is a situation where importance is to be attached to the content of speech, and the CPU 11 selects ALC in step S28.

On the other hand, when it is judged that no face is detected in the step S22, the situation determination unit 111 decides whether or not the shooting relates to shooting of landscape in step S24. In this case, the situation determination unit 111 makes a judgment based on the focal distance of the photographic lens 1, the distance of the photographic subject, the luminance distribution of image, the color information or the like. Alternatively, it may be configured such that when the photographer has selected "landscape mode", the situation determination unit 111 will judge that the shooting relates to shooting of landscape.

When it is judged that the shooting relates to shooting of landscape in step S24, it is a situation where importance is to be attached to ambience, and the CPU 11 performs the gain fixation processing in the step S27. When step S24 is denied, that is, the shooting does relate neither to shooting of a person nor to shooting of landscape, the situation determination unit 111 decides that in many cases there would be no speech of a person but the content of sounds in the surrounding would be important. Accordingly, the CPU 11 selects the ALC function in step S28.

FIG. 4 presents a flowchart illustrating the details of gain fixation processing. In step S271, the CPU 11 decides whether or not the input level of the audio signal is equal to or higher than a predetermined value. When the input level of the audio signal is equal to or higher than the predetermined value, the CPU 11 affirms step S271 and the control proceeds to step S272 and the CPU 11 sets the fixed value of the recording gain to "low". When the input level of the audio signal is below the predetermined value, the CPU 11 denies step S271 and the control proceeds to step S273 and the CPU 11 sets fixed value of the recording gain to "high". In this manner, it is configured such that the recording gain is set depending on the input level of voice, so that inconveniences such as reproduced sound being inaudible or occurrence of cracking can be avoided.

Note that it is configured in the above that the fixed value of recording gain can be selected from two options. However, it may be configured such that three or more options are provided and the fixed value of recording level can be set lower as the sound input level increases. On the contrary, it may be configured such that the gain fixation value is only one (there being no room for selection).

Further, a photographic angle may be taken into consideration in the selection of the fixed value of recording gain. For example, when shooting is performed in a telephotographic mode, it is highly possible that the photographic subject, that is, an audio source is positioned faraway, and the recording gain is set high.

According to the first embodiment explained above, the following advantageous effects can be obtained.
(1) The digital camera 100 includes the microphone 9, the situation determination unit 111, and the CPU 11. The microphone 9 obtains sounds in the surrounding and the situation determination unit 111 determines a situation of the surrounding when the sounds are obtained by the microphone 9. The CPU 11 applies to the sounds obtained by the microphone 9 either one of automatic level control in which gain is automatically controlled or gain fixation control in which gain is fixed to a constant value. In the automatic level control, the CPU 11 automatically controls the sound level to a constant value based on the results of determination by the situation determination unit 111. Therefore, since the device is configured to automatically select either ALC function or gain fixation in audio recording, the audio recording can be performed optimally without the photographer's awareness.

(2) When it is determined by the situation determination unit 111 that it is a situation in which importance is to be attached to the content of speech, the CPU 111 controls an automatic level control to be applied. This makes it possible to record voices of all the members at substantially the same recording level even when the distance of the microphone 9 differs from person to person or loudness of voice differs from person to person as in, for example, a situation of conference. As a result, in the reproduction mode, the voices of all the members can be reproduced at volumes of substantially the same level.

(3) Also, in a case where it is determined by the situation determination unit 111 that it is a situation in which importance is to be attached to ambience, the CPU 11 controls a gain fixation control to be applied. Accordingly, the gain fixation control is preferred in audio recording in the case where importance is to be attached to ambience and continuation of sounds as in movie shooting of a landscape, a concert or a sport.

(4) The manipulation unit 12 indicates either one of an automatic level control or the gain fixation control depending on the operation by the photographer. Then, when the manipulation unit 12 indicates any one of the automatic level control and the gain fixation control, the CPU 11 controls either one of the automatic level control and gain fixation control to be applied, putting priority to the indication by an indication unit. Therefore, audio recording can be performed with a gain that is achieved by one of the automatic level control and the gain fixation control which is desired by the photographer.

### -Second Embodiment-

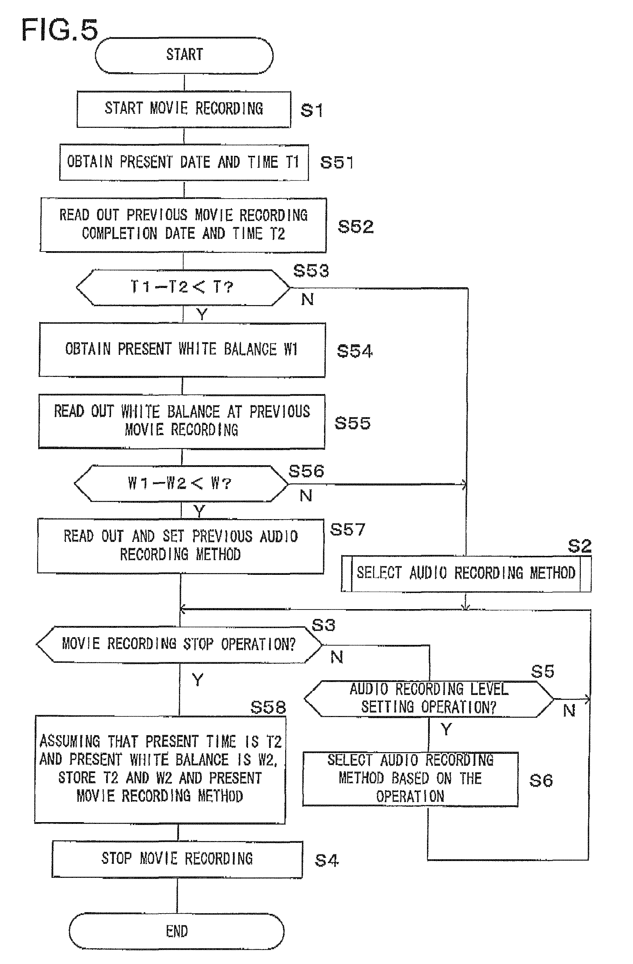

Referring to FIG 5, a second embodiment according to the present invention is explained. In the following explanation, same or like elements as those in the first embodiment are assigned same reference numbers and explanation will be focused on differences of the present embodiment from the first embodiment. The features that are not particularly explained are the same as those in the first embodiment. The present embodiment is different from the first embodiment in the following points. That is, in a case where a time interval between a last movie shooting time and a present movie shooting time is short and a difference in white balance between the last movie shooting time and the present movie shooting time is small, the same recording method as that used in the last movie shooting time is adopted unconditionally under a judgment that a scene similar to that in the last movie shooting is continuously shot. This can remove a sense of discomfort due to the fact that different recording methods are used for the same scene.

FIG. 5 shows processing procedures upon movie shooting according to the second embodiment (corresponding to FIG. 2). Note that the same steps as those in FIG. 2 arc assigned same step numbers.
Referring to FIG. 5, in step S1, the CPU 11 causes the image sensor 2 to start movie shooting, while in step S51, the CPU 11 obtains present date and time T1 from a built-in clock. In step S52, the CPU 11 reads out date and time T2 of completion of the last movie recording from the memory 10, and in step S53, T1-T2, that is, a time interval between the stop of the last movie recording and the start of the present movie recording is compared with a predetermined time T (for example, 30 minutes).

If T1-T2 is smaller than the predetermined time T, the CPU 11 affirms step S53 and the control proceeds to step S54 where the CPU 11 obtains a present white balance setting W1. The white balance is automatically set based on an output of ambient light sensor or the like when in an "automatic" mode while when in a "manual" mode, the white balance is selected by the photographer. In step S55, the CPU 11 reads out a white balance setting W2 in the last movie shooting from the memory 10 while in step S56, the CPU 11 compares W1-W2 with a predetermined value W. If W1-W2 is smaller than the predetermined value W, the situation determination unit 111 judges that the present scene is similar to the last scene and the CPU 11 affirms step S56, and the control proceeds to step S57. In step S57, the CPU 11 reads out the last recording method from the memory 10 and the CPU 11 sets the read out recording method as a present recording method. On the other hand, in case that the CPU 11 denies step S53 or S56, the control proceeds to step S2, where the CPU 11 selects the recording method by the procedure that is explained referring to FIG 3.

When a movie recording stop operation is confirmed in step S3, the CPU 11 affirms step S3 and the control proceeds to step S58. In step S58, the CPU 11 stores a present time T2 and a present white balance W2 as well as the movie recording method and the control proceeds to step S4.

In the above explanation, a time from the completion of the last movie recording and white balance are used in order to judge whether or not the present scene is similar to the last scene. However, in place of white balance or in addition to white balance, brightness distribution or color information may be used. Further, in a device that can obtain position information by, for example, a GPS receiver, it may be configured such that when a distance between a last shooting position and a present shooting position is smaller than a predetermined value, the present scene is judged to be similar to the last scene.

According to the second embodiment explained above, the following advantageous effects can be obtained in addition to the advantageous effects (1) to (4) obtained according to the first embodiment.
The situation determination unit 111 detects a change between the situation at the last audio recording time and the situation at the present audio recording time. When it is determined by the situation determination unit 111 that there is no change between the situation at the last audio recording time and the situation at the present audio recording time, the CPU 11 applies the control at the last audio recording time to the present audio recording time as a control. Therefore, in a case, for example, where movie shooting of a landscape is continuously transitioned to movie shooting of a conference, the gain fixation is automatically switched to the ALC function, so that troublesome manual switch operations by the photographer can be avoided.

### -Third Embodiment-

Referring to the drawings, a third embodiment according to the present invention is explained. In the following explanation, same or like constituent elements are assigned same reference numerals as those used in the first embodiment and explanation is focused on differences between the present embodiment and the first embodiment. Features that are not particularly explained are the same as those in the first embodiment. The present embodiment is different from the first embodiment in the following points. That is, according to the present embodiment, the camera has a microphone on each of a front side and a back side thereof and the present embodiment adopts a different recording method selection processing than the one used in the first embodiment.

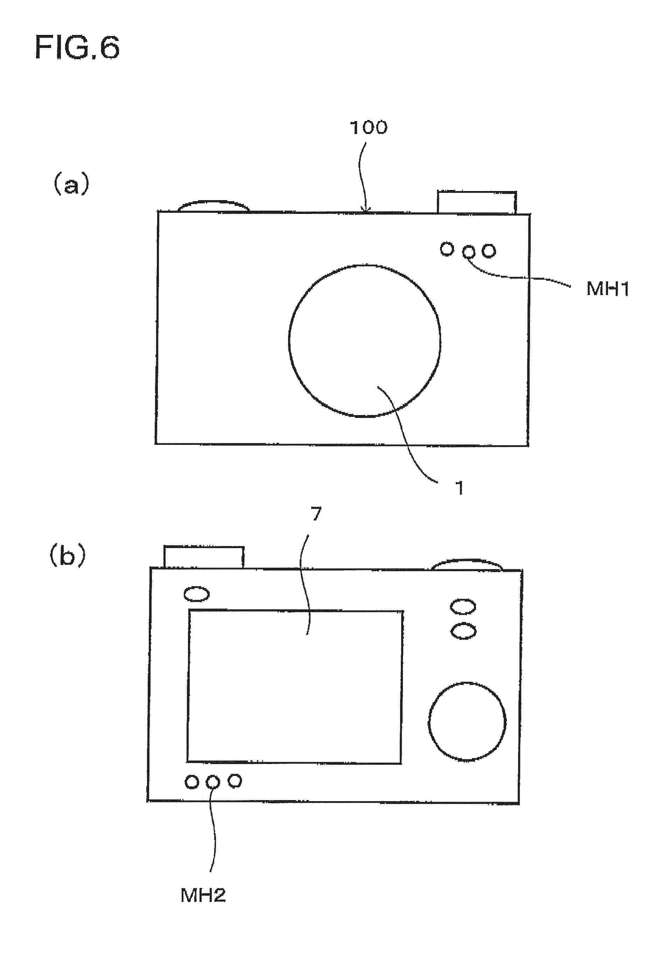

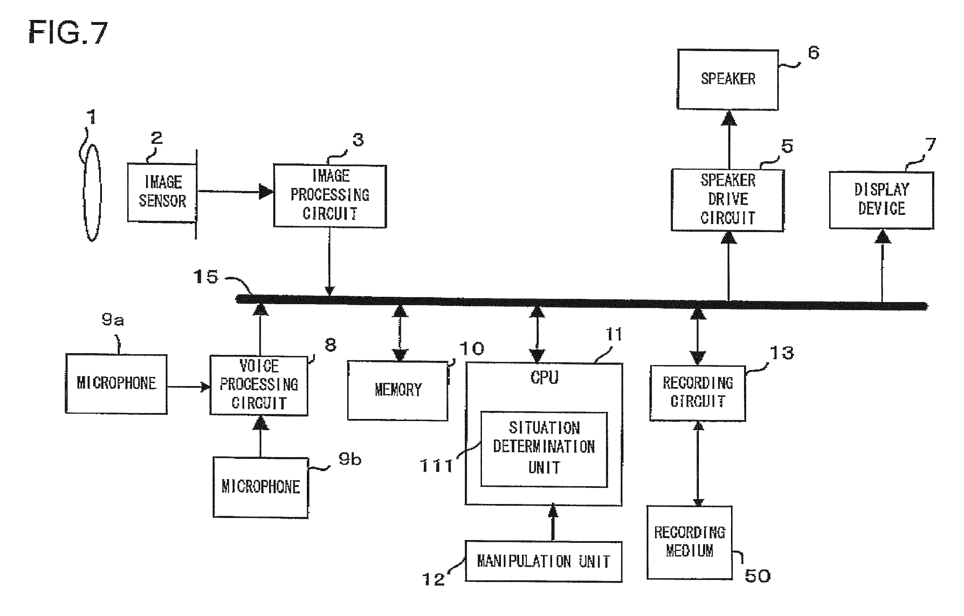

FIG. 6 presents a front elevation and a back side elevation or the digital camera 100 according to the third embodiment. FIG. 7 presents a block diagram of a control system of the digital camera 100 according to the third embodiment. At the front side of the camera body is provided the photographic lens 1 and on upper right side, a microphone hole MH1 is provided. At the back side of the camera body is provided the display device 7 such as a liquid crystal monitor or the like and on lower left side is provided a microphone hole MH2.

In the case of still image shooting, image capturing is performed by the image sensor 2 following to a release operation, and an image pickup signal is output from the image sensor 2. The image data created by the image processing circuit 3 using an image pickup signal is stored by the recording circuit 13 in the recording medium 50 such as a memory card. The image data is stored in the form of a still image file which can be processed by a computer.

In case of movie shooting, the movie shooting by the image sensor 2 is started following to the movie recording start operation, and the movie shooting is stopped following to the movie recording stop operation. In the meantime, the image pickup signal that is output from the image sensor 2 is converted into movie data by the image processing circuit 3. At the time of movie shooting, sounds are input and audio signals are output via a front side microphone 9a and back side microphone 9b (see FIG. 7). The audio signals are subjected to processing such as amplification in the audio processing circuit and are converted into predetermined audio data.

Here, the front side microphone 9a is arranged so as to face the microphone hole MH1 at the front side of the camera. It is used mainly for inputting sounds on the side of the photographic subject. The back side microphone 9b is arranged so as to face the microphone hole MH2 at the back side of the camera. It is used mainly for inputting sounds on the side of the photographer. The sounds on the side of the photographer are, for example, voices for explaining the situation from the photographer himself or herself. The photographer can select a mode in which a microphone is used at the time of movie shooting, for example, on a menu screen or the like. Options include "Use both of front side microphone 9a/back side microphone 9b", "Use only the front side microphone 9a", "Use only back side microphone 9b", and "Use none of the microphone". Use (non-use) of a microphone means that sounds input via the microphone are (are not) subjected to audio recording.

The movie data and audio data created as mentioned above are combined with each other to constitute the movie file. The movie file is recorded in the recording medium 50 via the recording circuit 13.

The CPU 11 controls each of the above circuits and various other circuits (not shown) to perform various processing including still image shooting, movie shooting and reproduction of images obtained thereby in response to the inputs from the manipulation unit 12 in the same manner as that in the first embodiment.

The procedure of movie shooting by the digital camera 100 according to the third embodiment is explained. When the movie recording start operation is performed, the CPU 11 executes the processing illustrated in the flowchart shown in FIG. 2. However, the digital camera 100 according to the third embodiment is different from the digital camera 100 according to the first embodiment in the recording method selection processing that is performed in step S2. Note that the gain fixation processing according to the third embodiment is the same as the processing shown in FIG. 4, Hereafter, the recording method selection processing according to the third embodiment is explained.

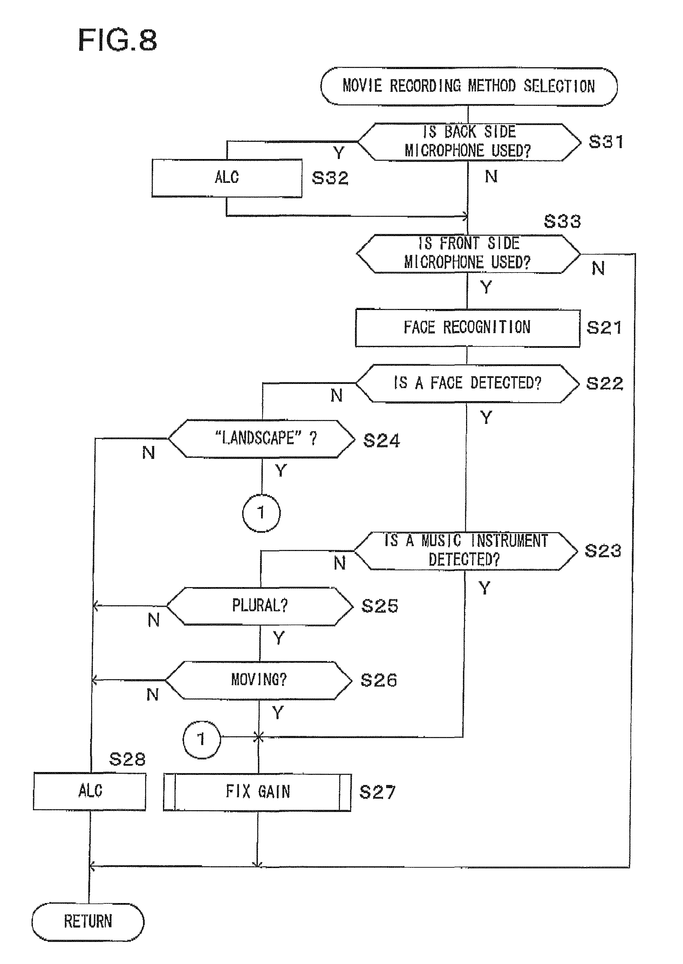

FIG. 8 presents a flowchart illustrating details of the recording method selection processing (step S2).
In step S31, the CPU 11 decides whether or not the back side microphone 9b is to be used. Use/non-use of a microphone is judged depending on the content of the above setting by the photographer. When the CPU 11 judges that the back side microphone 9b is to be used, the CPU 11 affirms step S31 and the control proceeds to step S32, where the CPU 11 selects ALC function for sounds input from the back side microphone 9b. That is, audio signals that are input from the back side microphone 9b corresponds mainly to voices of the photographer explaining, for example, the situation and hence the content of the speech is important. Therefore, the CPU 11 selects the ALC function so that even when the loudness of voice of the photographer varies, the speech can be reproduced at a constant reproduction level. When the ALC function is selected, the CPU 11 periodically checks the input level of voices until completion of movie recording and the audio processing circuit 8 automatically adjusts the recording gain so that the recording level can become substantially constant.

When the CPU 11 denies step S31, the sound input from the back side microphone 9b is not subjected to audio recording and the control proceeds to step S33, where it is judged whether or not to use the front side microphone 9a. When it is judged that the front side microphone 9a is not to be used, the CPU 11 denies step S33 so as not to subject the sound input from the front side microphone 9a to audio recording, and the control is returned. When the CPU 11 affirms step S33, that is, when the front side microphone 9a is to be used, the control proceeds to step S21. Processing in steps subsequent to step S21 relates to selection of a recording method for processing audio signal that is input from the front side microphone 9a. The CPU 11 performs processing similar to the processing of which the content is explained by using the flowchart shown in FIG. 3.

According to the third embodiment explained above, the following advantageous effects can be obtained in addition to the advantageous effects (1) to (4) obtained according to the first embodiment.
The microphone 9 includes the front side microphone 9a having a directivity in a direction toward a photographer and the back side microphone 9b having a directivity in a direction other than the direction toward the photographer. For processing voices obtained by the front side microphone 9a, the CPU 11 selects, based on the result of determination by the situation determination unit 111, any one of an automatic level control in which gain is automatically controlled such that the voice can be at a constant level and a gain fixation control in which gain is fixed to a certain value. Further, the CPU 11 controls the voices obtained by the back side microphone 9b by automatic level control, without resort to the result of determination by the situation determination unit 111. Therefore, even when the loudness of voice of the photographer varies, the content of speech such as explanation of situation spoken mainly by the photographer, of which the content is considered to be important, can be reproduced at a constant level.

### -Fourth Embodiment-

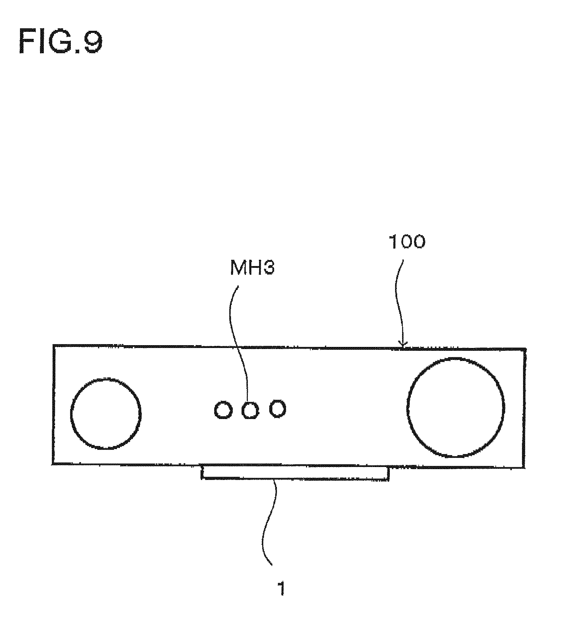

Referring to FIG. 9 to FIG. 11, a fourth embodiment according to the present invention is explained. In the following explanation, same or like constituent elements are assigned same reference numerals as those used in the third embodiment and explanation is focused on differences between the present embodiment and the third embodiment. Features that are not particularly explained are the same as those in the third embodiment. The present embodiment is different from the third embodiment in the following points. That is, according to the present embodiment, the camera has a microphone on the upper side of the camera and the present embodiment adopts a different recording method selection processing than the one used in the third embodiment.

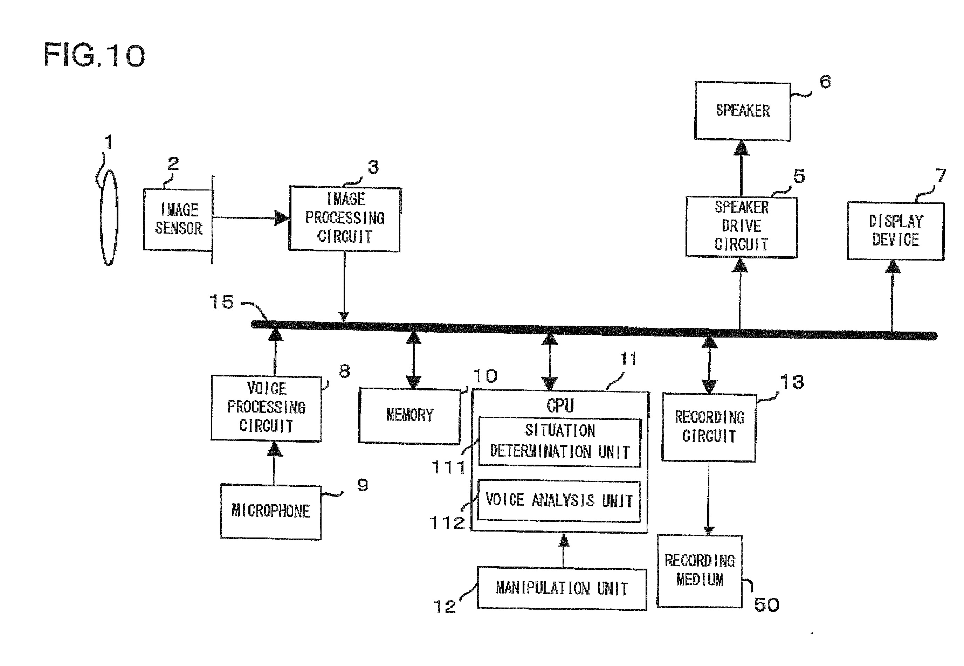

FIG. 9 presents a top view of the digital camera 100 according to the fourth embodiment and FIG. 10 presents a control block diagram for the digital camera 100. The digital camera 100 has only one microphone 9, The microphone 9 is arranged so as to face a microphone hole MH3 provided on the upper side of the camera in order to collect sounds on both the photographic subject side and the photographer side efficiently.

According to the present embodiment, in case the voices of the photographer are subjected to audio recording, the ALC function is used in the same manner as in the third embodiment. On the other hand, in case the sounds on the photographic subject side are subjected to audio recording, either one of the ALC function and the gain fixation is selected depending on the situation. However, according to the present embodiment, the camera has only one microphone 9, and hence, it is necessary to determine whether or not the input sound is a voice of the photographer by voice analysis.

To perform voice determination, the digital camera 100 is implemented with a voiceprint analysis function and a registration mode for the registration of the photographer's voice. That is, the CPU 11 functionally has a voice determination unit 112 to determine whether or not the sound obtained by the microphone 9 is a voice of a prescribed person. When a registration mode is set, the CPU 11 causes the display device 7 to display a message requesting the photographer to say something. When the photographer says something, the voice determination unit 112 of the CPU 11 performs a voiceprint analysis on audio data corresponding to an audio signal output from the microphone 9, and registers a result of the analysis in the memory 10 as a characteristic pattern of the voice of the photographer. Note that a plurality of characteristic patterns corresponding to a plurality of persons can be registered.

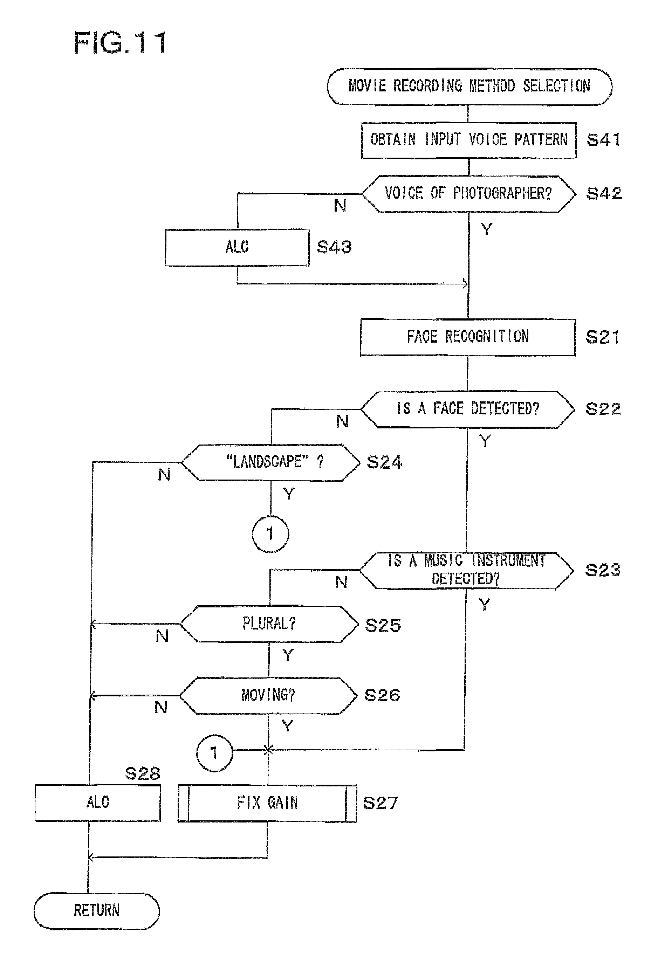

FIG. 11 shows details of the recording method selection processing according to the fourth embodiment. This corresponds to FIG. 8 in the third embodiment. The same steps as those shown in FIG. 8 are assigned the same step numbers. Note that the controls shown in FIG. 2 and FIG. 4 are also applied to the fourth embodiment.

Referring to FIG 11, in step S41, the voice determination unit 112 performs the voiceprint analysis on the audio data corresponding to the audio signal that is input via the microphone 9 to obtain a characteristic pattern of the input voice. In step S42, the voice determination unit 112 compares the characteristic pattern of the voice and the characteristic pattern that has been registered in the memory in advance. Then, if a difference between any one of the registered characteristic patterns and the obtained characteristic pattern is smaller than a predetermined value, the voice determination unit 112 judges that the input sound from the microphone 9 is a voice of the photographer and selects in step S43 the ALC function. On the other hand, if a difference between all the registered characteristic patterns and the obtained characteristic pattern is equal to or larger than the predetermined value, the voice determination unit 112 judges that the input sound from the microphone 9 is not a voice of the photographer (it being highly possible that it is a voice on the photographic subject side) and performs the processing in the above step S21 and subsequent steps.

According to the fourth embodiment explained above, the following advantageous effects can be obtained in addition to the advantageous effects (1) to (4) obtained according to the first embodiment.
The camera includes the voice determination unit 112 that determines whether or not the sound obtained by the microphone 9 is a voice of a prescribed person. If the voice determination unit 112 determines that the sound obtained by the microphone 9 is not a voice of the prescribed person, the CPU 11 applies, based on the result of the determination by the situation determination unit 111, either one of the automatic level control in which gain is automatically controlled such that the voice can be at a constant level and the gain fixation control in which gain is fixed to a certain value. Further, if the voice determination unit 112 determines that the sound obtained by the microphone 9 is a voice of the prescribed person, the CPU 11 applies the automatic level control to the voice obtained by the microphone 9 regardless of the result of the determination by the situation determination unit 111. Therefore, even when the loudness of voice of the photographer varies, the content of speech such as explanation of situation spoken mainly by the photographer, of which the content is considered to be important, can be reproduced at a constant level.

The first to fourth embodiments explained above may be modified as follows.
(1) The procedure for selecting the ALC function or the gain fixation is not limited to that shown in FIG. 3, FIG. 8 or FIG. 11. For example, in a device that can set a scene mode in advance, it may be configured such that if a "portrait mode" is selected as the scene modo, the CPU 11 selects the ALC function taking into consideration conversation between the photographer and the photographic subject. In addition, it may be configured such that if a face or faces of person(s) is/are detected, the control can be changed depending on whether a person or persons is/are detected. On the other hand, it may be configured such that if a motion of a person is detected (it being highly possible that a sport is involved), the CPU 11 selects the gain fixation, attaching importance to ambience regardless of the number of persons.

(2) Further, it may be configured such that the CPU 11 periodically performs selection processing whether to select the ALC function or the gain fixation during movie shooting. With this configuration, if, for example, movie shooting of a landscape is continuously transitioned to movie shooting of a conference, the gain fixation is automatically switched to the ALC function, so that it becomes unnecessary for the photographer to switch the control manually.

(3) In the above, the audio recording following to movie shooting has been explained. The above recording method selection control may also be used in audio recording in, for example, a digital camera that can record ambient sounds for only a certain length of time upon still image shooting. Furthermore, the above control may be applied to simple audio recording without accompanying shooting of movie or still image as far as the device is equipped with an image capturing means.

(4) Instead of the digital camera 100 provided with the microphone 9, the microphone 9 may be configured to be detachably attached to the digital camera 100.

In the above, various embodiments and modifications or variations have been explained. However, the present invention is not limited thereto. Other aspects that can be conceivable within the technical concept of the present invention are within the scope of the present invention.

The disclosure of the following priority applications is incorporated by reference herein:
Japanese Patent Application No. 2010-282914 (filed on December 20, 2010)
Japanese Patent Application No. 2010-282915 (filed on December 20, 2010).

## Claims

1. An audio control device comprising:
a situation determination unit that determines a situation of environment when a sound is obtained; and
a control unit that applies any one of automatic level control and a gain fixation control to a sound obtained by a sound obtaining unit, the control unit controlling gain automatically based on a result of determination by the situation determination unit such that a sound level is at a constant level in the automatic level control and fixing gain to a predetermined value in the gain fixation control.

2. An audio control apparatus according to claim 1, wherein
the sound obtaining unit includes a first obtaining unit that has a directivity in a direction toward a user and a second obtaining unit that has a directivity in a direction other than the direction toward the user, and
the control unit applies the automatic level control to a sound obtained by the first obtaining unit regardless of the result of determination by the situation determination unit and applies to a sound obtained by the second obtaining unit any one of the automatic level control in which gain is automatically controlled such that the sound level is at the constant level and the gain fixation control in which gain is fixed to the predetermined value based on the result of determination by the situation determination unit.

3. An audio control device according to claim 1, further comprising:
a voice determination unit that determines whether or not the sound obtained by the sound obtaining unit is a voice of a prescribed person, wherein
when the voice determination unit determines that the sound obtained by the sound obtaining unit is not a voice of the prescribed person, the control unit applies to the sound obtained by the obtaining unit any one of the automatic level control in which gain is automatically controlled such that the sound level is at a constant level and the gain fixation control in which gain is fixed to the predetermined value based on the result of determination by the situation determination unit, or when the voice determination unit determines that the sound obtained by the sound obtaining unit is the voice of the prescribed person, the control unit applies the automatic level control to the sound obtained by the obtaining unit regardless of the result of determination by the situation determination unit.

4. An audio control device according to any one of claims 1 to 3, wherein
the situation determination unit detects a difference in situation between a situation at previous audio recording and a situation at present audio recording, and
when the situation determination unit determines that there is no change in situation between the situation at the previous audio recording and the situation at the present audio recording, the control unit applies the control at the previous audio recording as a control for the present audio recording.

5. An audio control device according to any one of claims 1 to 4, wherein
when the situation determination unit determines that the situation is a situation in which the content of speech is important, the control unit applies the automatic level control.

6. An audio control device according to any one of claims I to 5, wherein
when the situation determination unit determines that the situation is a situation in which importance is to be attached to ambience, the control unit applies the gain fixation control.

7. An audio control device according to any one of claims 1 to 5, further comprising:
an indication unit that indicates any one the automatic level control and the gain fixation control depending on an operation by a user, wherein
when any one of the automatic level control and the gain fixation control is indicated by the indication unit, the control unit applies any one of the automatic level control and the gain fixation control, putting priority to the indication by the indication unit.

8. An audio control device according to any one of claims 1 to 7, wherein
when the control unit applies the gain fixation control, the control unit uses a gain corresponding to the sound level.

9. An audio control device according to any one of claims 1 to 8, further comprising:
a recording control unit that records the sound obtained by the sound obtaining unit in a recording medium.

10. An imaging device comprising:
an audio control device according to any one of claims 1 to 9; and
an image capturing unit that performs image capturing of a photographic subject, wherein
the situation determination unit determines a situation based on a result of the image capturing by the image capturing unit.

11. An imaging device according to claim 10, wherein
the situation determination unit detects a face of a person on an image captured by the image capturing unit, and
when the situation determination unit has detected the face of the person, the control unit applies the automatic level control or when the situation determination unit has not detected the face of the person, the control unit applies the gain fixation control.

12. An imaging device according to claim 11, wherein
when the situation determination unit detects a plurality of faces of the persons, the situation determination unit determines whether or not the persons are moving objects, and
when the situation determination unit has determined that the persons are moving objects, the control unit applies the automatic level control or when the situation determination unit has determined that the persons are not moving objects, the control unit applies the gain fixation control.
